# EUROPEAN PATENT APPLICATION

(11) **EP 1 460 678 A1**
(43) Date of publication of application: **22.09.2004**
(21) Application number: 01954400.6
(22) Date of filing: 31.07.2001
(51) Int. Cl.: H01L 21/205, H01L 21/302, H01L 21/285, C23C 16/44

(54) **METHOD AND APPARATUS FOR CLEANING AND METHOD AND APPARATUS FOR ETCHING**

(71) Applicant: L'AIR LIQUIDE, SOCIETE ANONYME POUR L'ETUDE ET L'EXPLOITATION DES PROCEDES GEORGES CLAUDE, 75321 Paris Cédex 07 (FR)
(72) Inventor: SONOBE, Jun, Tsukuba-shi, Ibaraki 300-3261 (JP); KURODA, Yoshikuni, Tsukuba-shi, Ibaraki 305-0821 (JP); ZILS, Regis, Tsukuba-shi, Ibaraki 305-0051 (JP); INO, Minoru, Tsukuba-shi, Ibaraki 300-2617 (JP); KIMURA, Takako, Ami-machi, Inashiki-gun, Ibaraki 300-115 (JP); NISHIKAWA, Yukinobu, Seya-ku, Yokohama-shi, Kanagawa 246-0021 (JP)
(74) Representative: Vesin, Jacques
(86) International application number: PCT/JP2001/006604
(87) International publication number: WO 2003/012843

(57) **Abstract**

A cleaning apparatus (30) is connected to the treating chamber (12) of a CVD apparatus (10) for silicon. The cleaning apparatus (30) has a first, second, and third gas sources (32, 34, 36) and chlorine gas, fluorine gas, and inert gas flow from these sources through independently MFCs (38a, 38b, 38c), and are introduced at independently controlled flow rates. Theses gases are combined and mixed in the pipe (42) to produce a mixed gas. This mixed gas is passed through a heated reactor (44), for example, a heat exchanger, and the chlorine gas is reacted with the fluorine gas to produce a product gas containing a chlorine fluoride gas such as CIF₃. The product gas is passed through a cooler (46), an analyzer 48, and a buffer 54, and is fed into the treating chamber (12).

## Description

### Technical Field

This invention relates to a cleaning method and apparatus and an etching method and apparatus for semiconductor processing systems wherein said cleaning method and apparatus and said etching method and apparatus use an interhalogen fluorine compound gas (IFCG). Here, semiconductor processing denotes the various processes that are executed in order to fabricate a semiconductor device - or a structure that connects to a semiconductor device - on a treatment substrate through the formation thereon of a semiconductor layer, insulating layer, conductive layer, etc., in a prescribed pattern. Said treatment substrate can be, for example, a semiconductor wafer or an LCD substrate, and the connecting structure can be, for example, a conductor, trace, or electrode.

### Background Art

Interhalogen fluorine compound gases, such as CIF₃, are used in semiconductor processing systems to etch treatment substrates and to clean the treating chambers and exhaust pipe systems. For example, CIF₃ (chlorine trifluoride) gas is utilized as a cleaning gas for the CVD equipment that is used to form films of silicon (Si), polysilicon, amorphous silicon, silicon oxide (SiO₂), silicon nitride (Si₃N₄), tungsten silicide (WSi₂), titanium-tungsten (TiW), tantalum oxide (Ta₂O₅), and silicon-germanium (SiGe). An advantage of CIF₃ gas is its ability to react without using a plasma; depending on the particular case, it will react even at ambient temperature.

CIF₃ gas is filled as a high-purity liquefied gas into metal cylinders and is delivered in this form to the user's site. At the user's site, the gas-phase portion of the CIF₃ is withdrawn from the cylinder, is depressurized to the vapor pressure prevailing at the cylinder temperature at this point (or to below this vapor pressure), and is then transported to the particular semiconductor fabrication apparatus.

Since CIF₃ has a low boiling point at 12°C, a precise temperature control must be exercised - in particular when large CIF₃ gas flow rates are required - over the associated pumps and supply conduit system in order to obtain the required quantities of the gas and in order to prevent reliquefaction along the conduit pathways. However, CIF₃ is very corrosive and strongly oxidizing and in particular has a very high reactivity in its liquid phase. This places limitations from a materials standpoint on the ability to heat the pumps and conduits, while at the same time heating the pumps and conduits is also undesirable from a practical standpoint. In addition, the storage and transport of this highly reactive liquefied CIF₃ gas is tightly regulated in the United States and Europe, which places limitations on its range of applications notwithstanding the fact that it is a highly desirable cleaning gas.

In another vein, since very high purity levels are not required when CIF₃ is used as a cleaning gas, instances occur in which the CIF₃ purity required by the user does not match the cost of CIF₃ production. Moreover, depending on the particular process involved, it may be preferable to admix different components, for example, CIF or CIF₅, rather than employ a process gas composed of only CIF₃. Again depending on the particular process involved, it may even be desirable in some cases to make CIF or CIF₅ the main component. At the present time, a means such as the addition of a separate process for producing the process gas is required when it is desired to make these types of adjustments in the gas components as a function of the particular process.

### Disclosure of the Invention

This invention was developed in view of the problems described above for the prior art. The object of this invention is to provide improvements in the safety, cost, and flexibility of the IFCG-based cleaning methods and apparatuses and IFCG-based etching methods and apparatuses that are used in semiconductor processing systems.

This invention, which achieves the aforesaid object, is essentially characterized by the onsite and on-demand production and supply of IFCG. For the present purposes, onsite means that the IFCG-producing mechanism is combined with the main processing mechanism of the semiconductor processing system. On-demand is taken to mean that the process gas can be supplied in accordance with the timing required by the main processing mechanism and in accordance with any component adjustment required by the main processing mechanism.

A first aspect of this invention is a cleaning method that removes by-product containing material selected from the group consisting of Si, Mo, Ta, W, SiOₓ, SiNₓ, SiON, SiC, SiGe, TaSiₓ, TaOₓ, WSiₓ, TiC, TiN, TiW, BN, and indium tin oxide (ITO), that has accumulated in the treating chamber of a semiconductor processing system, wherein said cleaning method is provided with
a process comprising the formation of a mixed gas by mixing the gases afforded by independently introducing a nonfluorine first halogen gas and fluorine gas from, respectively, a first gas source and a second gas source, and selectively introducing inert gas from a third gas source, and
a process in which a product gas containing IFCG is produced by feeding the aforesaid mixed gas into a heated reactor and heating said mixed gas to a temperature at which the first halogen gas and fluorine gas react, and in which said product gas is fed concurrent with its production into the aforesaid treating chamber.

According to a second aspect of this invention, the first halogen gas : fluorine gas : inert gas volumetric ratio in the mixed gas in the method of the first aspect is established at 10 - 90: 10 - 90 : 0 - 90.

According to a third aspect of this invention, in the method of the first or second aspect, the first halogen gas is chlorine gas and the temperature to which the mixed gas is heated by the aforesaid heated reactor is 200°C to 400°C.

According to a fourth aspect of this invention, the aforesaid inert gas in the method of the first, second, or third aspect is helium.

A fifth aspect of this invention comprises a cleaning apparatus that removes by-product containing material selected from the group consisting of Si, Mo, Ta, W, SiOₓ, SiNₓ, SiON, SiC, SiGe, TaSiₓ, TaOₓ, WSiₓ, TiC, TiN, TiW, BN, and ITO, that has accumulated in the treating chamber of a semiconductor processing system, wherein said cleaning apparatus is provided with
an upstream section that forms a mixed gas by mixing the gases afforded by the independent introduction of a nonfluorine first halogen gas and fluorine gas from, respectively, a first gas source and a second gas source, and the selective introduction of inert gas from a third gas source, and
a downstream section that produces a product gas containing IFCG by feeding the aforesaid mixed gas into a heated reactor and heating said mixed gas to a temperature at which the first halogen gas and fluorine gas react, and that feeds said product gas concurrent with its production into the aforesaid treating chamber.

According to a sixth aspect of this invention, the upstream section in the apparatus of the fifth aspect is provided with a controller that can vary the first halogen gas : fluorine gas : inert gas volumetric ratio in the aforesaid mixed gas through independent adjustment of the individual flow rates of the first halogen gas, fluorine gas, and inert gas.

According to a seventh aspect of this invention, the heated reactor in the apparatus of the fifth or sixth aspect is provided with a reaction chamber and an upstream conduit that introduces the aforesaid mixed gas into said reaction chamber, wherein said reaction chamber and said upstream conduit are composed of a highly thermoconductive material that is highly resistant to corrosion by the aforesaid product gas, the aforesaid upstream conduit forms a heat-exchange section by wrapping around the aforesaid periphery, and said heat-exchange section is heated from the periphery by a heater.

An eighth aspect of this invention comprises a method for etching in a semiconductor processing system, that etches a first film on a treatment substrate, said first film substantially comprising material selected from the group consisting of Si, SIPOS (semi-insulating polycrystalline silicon), Ta, and TaSiₓ, wherein said etching method is provided with
a process comprising the formation of a mixed gas by mixing the gases afforded by independently introducing a nonfluorine first halogen gas and fluorine gas from, respectively, a first gas source and a second gas source, and selectively introducing inert gas from a third gas source, and
a process in which a product gas containing IFCG is produced by feeding the aforesaid mixed gas into a heated reactor and heating said mixed gas to a temperature at which the first halogen gas and fluorine gas react, and in which said product gas is fed concurrent with its production into the aforesaid treating chamber.

According to a ninth aspect of this invention, a second film is present in the method of the eighth aspect on the aforesaid treatment substrate, wherein said second film substantially comprises material selected from the group consisting of SiO₂, SiNₓ, SiON, TaOₓ, and photoresists and the aforesaid etching method etches the aforesaid first film selectively relative to the said second film.

A tenth aspect of this invention is an etching apparatus in a semiconductor processing system, that etches a first film on a treatment substrate, said first film substantially comprising material selected from the group consisting of Si, SIPOS, Ta, and TaSiₓ, wherein said etching apparatus is provided with
a treating chamber that holds the aforesaid treatment substrate,
an upstream section that forms a mixed gas by mixing the gases afforded by the independent introduction of a nonfluorine first halogen gas and fluorine gas from, respectively, a first gas source and a second gas source, and the selective introduction of inert gas from a third gas source, and
a downstream section that produces a product gas containing IFCG by feeding the aforesaid mixed gas into a heated reactor and heating said mixed gas to a temperature at which the first halogen gas and fluorine gas react, and that feeds said product gas concurrent with its production into the aforesaid treating chamber.

According to an eleventh aspect of this invention, the heated reactor in the apparatus of the tenth aspect is provided with a reaction chamber and an upstream conduit that introduces the aforesaid mixed gas into said reaction chamber, wherein said reaction chamber and said upstream conduit are composed of a highly thermoconductive material that is highly resistant to corrosion by the aforesaid product gas, the aforesaid upstream conduit forms a heat-exchange section by wrapping around the aforesaid periphery, and said heat-exchange section is heated from the periphery by a heater.

### Brief Description of the Drawings

Figure 1 contains a schematic drawing that illustrates a cleaning apparatus that is an embodiment of the present invention. This cleaning apparatus removes by-product that has accumulated within the treating chamber of a semiconductor processing system.
Figure 2 contains a schematic drawing that illustrates, as another embodiment of the present invention, an etching apparatus in a semiconductor processing system.
Figure 3 contains a perspective drawing that illustrates a heated reactor/cooler combined structure that is usable in the apparatuses shown in Figures 1 and 2.
Figure 4 contains a cross-sectional drawing that illustrates the internal structure of the essential features of the heated reactor shown in Figure 3.

### Best Mode for Carrying Out the Invention

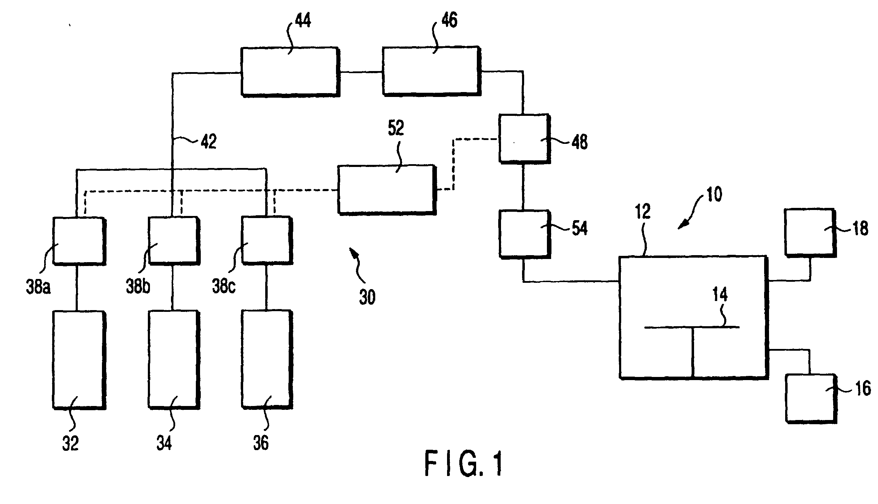

Figure 1 contains a schematic drawing of a cleaning apparatus that is an embodiment of this invention and that removes by-product that has accumulated within the treating chamber of a semiconductor processing system. This cleaning apparatus **30** may be connected to, for example, a CVD apparatus **10** set up to form a silicon film on a treatment substrate, e.g., a semiconductor wafer or LCD substrate.

The CVD apparatus **10** is provided with a treating chamber **12** that holds the treatment substrate. Disposed within the treating chamber **12** is a platform **14** for mounting the treatment substrate. The lower region of the treating chamber **12** is connected to an exhaust system **16** that exhausts the interior and establishes a vacuum therein. The upper region of the treating chamber **12** is connected to a feed system **18** that supplies process gas, for example, SiH₄.

The repetition of film-forming processes in such a CVD apparatus **10** causes the accumulation of by-product (main component = Si) on the inner walls of the treating chamber **12** and the inner walls of the conduits of the exhaust system **16**. The cleaning apparatus **30** in accordance with this invention is used to remove this by-product.

The cleaning apparatus **30** is provided with a first gas source **32**, a second gas source **34**, and a third gas source **36** in order to supply, respectively, chlorine (Cl₂) gas, fluorine (F₂) gas, and inert gas. The chlorine gas source **32** comprises a cylinder filled with the liquefied gas. Feed of the chlorine gas is relatively easy due to the high vapor pressure involved. The fluorine second gas source **34**, on the other hand, comprises a gas generator that produces fluorine gas by electrolysis, although the fluorine gas could also be supplied as a high-pressure gas from a cylinder.

The inert gas functions as a diluent gas or carrier gas, and any inert gas can be used, e.g., helium, argon, nitrogen, and so forth. However, the use of helium with its high thermal conductivity is particularly preferred in order to facilitate heating of the mixed gas, vide infra. Use of the inert gas may be omitted depending on the particular treatment, i.e., introduction of the inert gas is carried out on a selective basis.

The chlorine gas from the first gas source **32**, the fluorine gas from the second gas source **34**, and the inert gas from the third gas source **36** pass through, respectively, mass flow controller (MFC) **38a**, MFC **38b**, and MFC **38c**, which results in their introduction with their flow rates under separate and independent control. The independently introduced chlorine gas, fluorine gas, and inert gas are combined and mixed in the conduit **42** to form a mixed gas. The chlorine gas : fluorine gas : inert gas volumetric ratio established in this mixed gas should be 10 - 90 : 10 - 90 : 0 - 90.

The mixed gas generated in this manner is transported into a heated reactor **44**, for example, a heat exchanger, and is heated to 200°C to 400° and preferably 250°C to 350°C. This serves to produce a product gas containing chlorine fluoride gas, e.g., CIF₃ gas, through reaction of the chlorine gas and fluorine gas. This product gas, which will contain CIF₃ gas as its main component along with other chlorine fluoride gases (CIF, CIF₅, etc.), by-products, and unreacted gases, is cooled by the cooler **46** to around room temperature - where CIF₃ does not liquefy - and is discharged at a pressure at which the CIF₃ does not liquefy.

The product gas withdrawn from the cooler **46** is first passed through an analyzer **48** that measures the interhalogen fluorine compound. The measurement results afforded by the analyzer **48** are fedback to the main controller **52**, and the MFCs **38a, 38b,** and **38c** are adjusted on the basis of these measurement results. This effects adjustment in such a manner that the chlorine gas : fluorine gas : inert gas volumetric ratio in the mixed gas is brought to the prescribed value.

The flow rate and pressure of the product gas are then adjusted in the buffer **54** so as to compatibilize these parameters with the conditions in the treating chamber **12** of the CVD apparatus **10**. After this adjustment the product gas is fed to the treating chamber **12**. The buffer **54** can also be executed as a temporary storage section that carries out liquefaction of the product gas and its ensuing re-volatilization. This enables the removal of solids and unreacted volatile gases, gaseous by-products, and impurity gases from the product gas in the buffer **54**. The chlorine fluoride gas (e.g., CIF₃ gas) in the product gas fed into the treating chamber **12** reacts with the by-product (main component = Si) that has accumulated on the inner walls of the treating chamber **12** and the inner walls of the exhaust system **16** and thereby debonds same from these inner walls. The debonded by-product becomes entrained in the exhaust flow produced by the action of the exhaust system **16** and is flushed from the CVD apparatus **10**.

While the embodiment under consideration involves the combination of the cleaning apparatus **30** with a silicon CVD apparatus **10**, chlorine fluoride gas is also effective for the removal of substances other than silicon (silicon includes polysilicon and amorphous silicon). These substances other than silicon can be specifically exemplified by Mo, Ta, W, SiOₓ, SiNₓ, SiON, SiC, SiGe, TaSiₓ, TaOₓ, WSiₓ, TiC, TiN, TiW, BN, and ITO. Thus, the cleaning apparatus **30** can be effectively used for the cleaning, inter alia, of CVD equipment and etching equipment in which by-product containing material selected from the aforesaid material group has been produced by the particular primary process implemented in the equipment.

### Experiment

A mixed gas of 30 SCCM chlorine gas, 100 SCCM fluorine gas, and 100 SCCM helium was produced and continuously fed at an internal system pressure of 836 torr into a heated reactor **44** comprising a nickel heat exchanger heated to 250°C to 350°C. As a result, a product gas was obtained that in the vicinity of the outlet from the heated reactor **44** had a CIF₃ concentration of 10% to 30%, giving a CIF₃ yield of 60% to 80%.

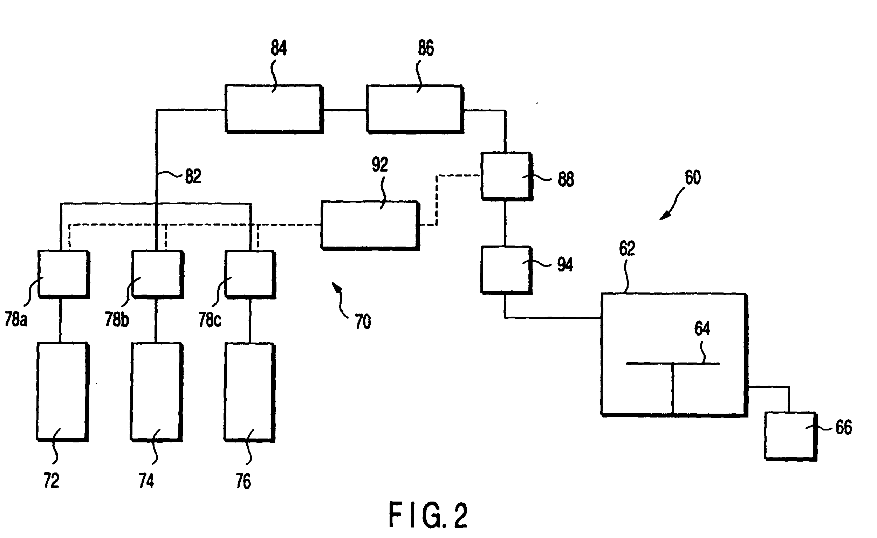

Figure 2 contains a schematic drawing of an etching apparatus that is another embodiment of this invention, said etching apparatus residing in a semiconductor processing system. This etching apparatus **60** can be used, for example, to etch an Si film on a treatment substrate in preference to an SiO₂ film (selective etching). The treatment substrate can be, for example, a semiconductor wafer or LCD substrate.

The etching apparatus **60** is provided with a treating chamber **62** that holds the treatment substrate. Disposed within the treating chamber **62** is a platform **64** for mounting the treatment substrate. The lower region of the treating chamber **62** is connected to an exhaust system **66** that exhausts the interior and establishes a vacuum therein. The upper region of the treating chamber **62** is connected to a feed system **70** that supplies etching gas. The feed system **70** in the etching apparatus **60** has the same structure as the cleaning apparatus **30** that is illustrated in Figure 1.

More specifically, this feed system **70** is provided with a first gas source **72**, a second gas source **74**, and a third gas source **76** in order to supply, respectively, chlorine (Cl₂) gas, fluorine (F₂) gas, and inert gas. The chlorine gas from the first gas source **72**, the fluorine gas from the second gas source **74**, and the inert gas from the third gas source **76** pass through, respectively, MFC **78a**, MFC **78b**, and MFC **78c**, which results in their introduction with their flow rates under separate and independent control. The independently introduced chlorine gas, fluorine gas, and inert gas are combined and mixed in the conduit **82** to form a mixed gas. The chlorine gas : fluorine gas : inert gas volumetric ratio established in this mixed gas should be 10 - 90 : 10 - 90 : 0 - 90.

The mixed gas generated in this manner is transported into a heated reactor **84**, for example, a heat exchanger, and is heated to 200°C to 400°C and preferably 250°C to 350°C. This serves to produce a product gas containing chlorine fluoride gas, e.g., CIF₃ gas, through reaction of the chlorine gas and fluorine gas. This product gas, which will contain CIF₃ gas as its main component along with other chlorine fluoride gases (CIF, CIF₅, etc.), by-products, and unreacted gases, is cooled by the cooler **86** to around room temperature - where CIF₃ does not liquefy - and is discharged at a pressure at which the CIF₃ does not liquefy.

The product gas withdrawn from the cooler **86** is first passed through an analyzer **88** that measures the interhalogen fluorine compound. The measurement results afforded by the analyzer **88** are fedback to the main controller **92**, and the MFCs **78a**, **78b**, and **78c** are adjusted on the basis of these measurement results. This effects adjustment in such a manner that the chlorine gas : fluorine gas : inert gas volumetric ratio in the mixed gas is brought to the prescribed value.

The flow rate and pressure of the product gas are then adjusted in the buffer **94** so as to compatibilize these parameters with the conditions prevailing in the treating chamber **12** of the CVD apparatus **10**. After this adjustment the product gas is fed to the treating chamber **12**. The buffer **94** can also be executed as a temporary storage section that carries out liquefaction of the product gas and its ensuing re-volatilization. This enables the removal of solids and unreacted volatile gases, gaseous by-products, and impurity gases from the product gas in the buffer **94**. The chlorine fluoride gas (e.g., CIF₃ gas) in the product gas fed into the treating chamber **62** reacts with Si film on the treatment substrate in preference to SiO₂ film on the treatment substrate, thereby etching the former. The etching product becomes entrained in the exhaust flow produced by the action of the exhaust system **66** and is flushed from the etching apparatus **60**.

In the embodiment under consideration, the etching apparatus **60** has been styled as an apparatus for etching a first film comprising Si film on a treatment substrate selectively with respect to a second film comprising SiO₂ film. However, chlorine fluoride gas is also effective for the selective etching of material combinations other than the Si film/SiO₂ film combination. Specifically, the first film, i.e., the film that is preferentially etched, can substantially comprise material selected from the group consisting of Si, SIPOS, Ta, and TaSiₓ. The second film, i.e., the film that is not preferentially etched, can substantially comprise material selected from the group consisting of SiO₂, SiNₓ, SiON, TaOₓ, and photoresists.

The cleaning apparatus **30** and the etching apparatus **60** described in the preceding have the ability to both produce and supply chlorine fluoride gas, e.g., CIF₃ gas, at the user's site using chlorine gas, fluorine gas, and inert gas as gas sources. This extinguishes the operational and regulatory problems associated with the supply of chlorine fluoride gas, e.g., CIF₃ gas, to the user's site as a liquefied gas in cylinders. More particularly, the apparatuses **30** and **60** have the ability to adjust the product gas composition in response to the particular process (i) by free variation of the chlorine gas : fluorine gas : inert gas volumetric ratio in the mixed gas over the above-specified range and/or (ii) by free variation of the heating temperature for the mixed gas over the above-specified range.

Other types of interhalogen fluorine compound gases can be generated and supplied by using another halogen gas (other than fluorine) in place of chlorine gas as the gas in the first gas source (**32**, **72**). For example, the use of bromine (Br₂) gas as the gas in the first gas source **32** enables the supply of product gas containing at least 1 of BrF, BrF₃, and BrF₅, while the use of iodine (I₂) gas as the gas in the first gas source **32** enables the supply of product gas containing at least 1 of IF, IF₃, IF₅, and IF₇. An appropriate process pressure and temperature should be selected in correspondence to the source gas used when the production and supply of these other IFCGs is being pursued.

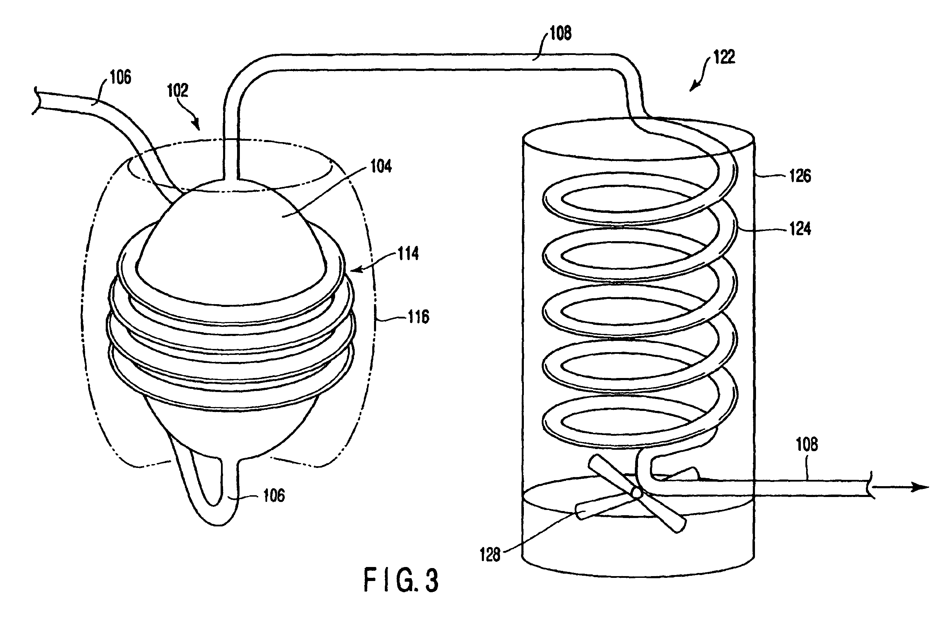

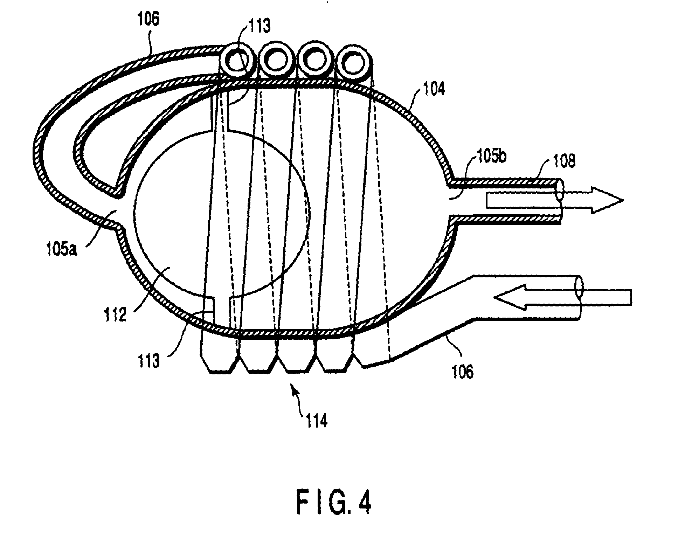

Figure 3 contains a perspective drawing that illustrates a structure in which a heated reactor **102** and a cooler **122** are combined. Figure 4 contains a cross-sectional drawing that illustrates the internal structure of the essential features of the heated reactor **102**. This heated reactor **102** and cooler **122** can be used for the heated reactor **44** and cooler **46** in the apparatus illustrated in Figure 1 and for the heated reactor **84** and cooler **86** in the apparatus illustrated in Figure 2.

The heater **102** is provided with a reaction chamber **104** that is formed by an oval-shaped casing and that has a first port **105a** and a second port **105b**. The upstream conduit **106** is connected to the first port **105a** in order to introduce a mixed gas of chlorine gas, fluorine gas, and inert gas. The downstream conduit **108** is connected to the second port **105b** in order to withdraw the gas produced by the reaction chamber **104**. A baffle member **112** is disposed within the reaction chamber **104** facing the first port **105a**. This baffle member **112** is composed of a spherical element and is fixed by welding through a suitable spacer **113** to the inner surface of the reaction chamber **104**. The combination of the oval shape of the reaction chamber **104** and the spherical shape of the baffle member **112** functions to stop the generation of gas drift (gas stagnation) in the reaction chamber **104**. The reaction chamber **104**, the conduits **106** and **108**, the baffle member **112**, and the spacer **113** are composed of highly thermoconductive material that is strongly resistant to corrosion by CIF₃, for example, Ni.

The upstream conduit **106** wraps the periphery of the reaction chamber **104** to form a heat exchanger **114**. This heat exchanger **114** is also completely enveloped by a jacket heater **116** and is heated from the periphery. The jacket heater **116** comprises an electrically controlled fabric-type heater comprising resistance heating wire embedded in heat-resistant nonwoven fabric.

The cooler **122** is provided with a coil **124** formed by the spiral coiling of the downstream conduit **108**. This coil **124** is held within a cylindrical casing **126**, and a fan **128** is disposed at the port at the lower end thereof. Thus, the cooler **122** has an air-cooled structure in which the gas in the coil **124** is cooled to around room temperature by the fan.

The integral formation of the heat exchanger **114** on the periphery of the reaction chamber **104** in accordance with the heated reactor **102** illustrated in Figures 3 and 4 enables the size of the reactor to be reduced and enables a good thermal efficiency to be obtained.

As has been explained in detail in the preceding, this invention, because it enables the onsite and on-demand supply of IFCG-containing product gas, can improve the safety, cost, and flexibility of the cleaning methods and apparatuses and etching methods and apparatuses in semiconductor processing systems.

## Claims

1. Cleaning method that removes by-product containing material selected from the group consisting of Si, Mo, Ta, W, SiOₓ, SiNₓ, SiON, SiC, SiGe, TaSiₓ, TaOₓ, WSiₓ, TiC, TiN, TiW, BN, and ITO, that has accumulated in the treating chamber of a semiconductor processing system, wherein said cleaning method is provided with
a process comprising the formation of a mixed gas by mixing the gases afforded by independently introducing a nonfluorine first halogen gas and fluorine gas from, respectively, a first gas source and a second gas source, and selectively introducing inert gas from a third gas source, and
a process in which a product gas containing an interhalogen fluorine compound gas is produced by feeding the aforesaid mixed gas into a heated reactor and heating said mixed gas to a temperature at which the first halogen gas and fluorine gas react, and in which said product gas is fed concurrent with its production into the aforesaid treating chamber.

2. The method described in Claim 1, in which the first halogen gas : fluorine gas : inert gas volumetric ratio established in the mixed gas is 10 - 90 10 - 90 : 0 - 90.

3. The method described in Claim 1 or 2, in which the first halogen gas is chlorine gas and the temperature to which the aforesaid mixed gas is heated by the aforesaid heated reactor is 200°C to 400°C.

4. The method described in any of Claims 1 through 3, in which the inert gas is helium.

5. Cleaning apparatus that removes by-product containing material selected from the group consisting of Si, Mo, Ta, W, SiOₓ, SiNₓ, SiON, SiC, SiGe, TaSiₓ, TaOₓ, WSiₓ, TiC, TiN, TiW, BN, and ITO, that has accumulated in the treating chamber of a semiconductor processing system, wherein said cleaning apparatus is provided with
an upstream section that forms a mixed gas by mixing the gases afforded by the independent introduction of a nonfluorine first halogen gas and fluorine gas from, respectively, a first gas source and a second gas source, and the selective introduction of inert gas from a third gas source, and
a downstream section that produces a product gas containing an interhalogen fluorine compound gas by feeding the aforesaid mixed gas into a heated reactor and heating said mixed gas to a temperature at which the first halogen gas and fluorine gas react, and that feeds said product gas concurrent with its production into the aforesaid treating chamber.

6. The apparatus described in Claim 5, in which the aforesaid upstream section is provided with a controller that can vary the first halogen gas : fluorine gas : inert gas volumetric ratio in the aforesaid mixed gas through independent adjustment of the individual flow rates of the first halogen gas, fluorine gas, and inert gas.

7. The apparatus described in Claim 5 or 6, in which the aforesaid heated reactor is provided with a reaction chamber and an upstream conduit that introduces the aforesaid mixed gas into said reaction chamber, wherein said reaction chamber and said upstream conduit are composed of a highly thermoconductive material that is highly resistant to corrosion by the aforesaid product gas, the aforesaid upstream conduit forms a heat-exchange section by wrapping around the aforesaid periphery, and said heat-exchange section is heated from the periphery by a heater.

8. Method for etching in a semiconductor processing system, that etches a first film on a treatment substrate, said first film being substantially composed of material selected from the group consisting of Si, SIPOS, Ta, and TaSiₓ, wherein said etching method is provided with
a process comprising the formation of a mixed gas by mixing the gases afforded by independently introducing a nonfluorine first halogen gas and fluorine gas from, respectively, a first gas source and a second gas source, and selectively introducing inert gas from a third gas source, and
a process in which a product gas containing an interhalogen fluorine compound gas is produced by feeding the aforesaid mixed gas into a heated reactor and heating said mixed gas to a temperature at which the first halogen gas and fluorine gas react, and in which said product gas is fed concurrent with its production into the aforesaid treating chamber.

9. The method described in Claim 8, in which a second film is present on the aforesaid treatment substrate, wherein said second film is substantially composed of material selected from the group consisting of SiO₂, SiNₓ, SiON, TaOₓ, and photoresists and the aforesaid etching method etches the aforesaid first film selectively relative to said second film.

10. Etching apparatus in a semiconductor processing system, that etches a first film on a treatment substrate, said first film being substantially composed of material selected from the group consisting of Si, SIPOS, Ta, and TaSiₓ, wherein said etching apparatus is provided with
a treating chamber that holds the aforesaid treatment substrate,
an upstream section that forms a mixed gas by mixing the gases afforded by the independent introduction of a nonfluorine first halogen gas and fluorine gas from, respectively, a first gas source and a second gas source, and the selective introduction of inert gas from a third gas source, and
a downstream section that produces a product gas containing an interhalogen fluorine compound gas by feeding the aforesaid mixed gas into a heated reactor and heating said mixed gas to a temperature at which the first halogen gas and fluorine gas react, and that feeds said product gas concurrent with its production into the aforesaid treating chamber.

11. The apparatus described in Claim 10, in which the aforesaid heated reactor is provided with a reaction chamber and an upstream conduit that introduces the aforesaid mixed gas into said reaction chamber, wherein said reaction chamber and said upstream conduit are composed of a highly thermoconductive material that is highly resistant to corrosion by the aforesaid product gas, the aforesaid upstream conduit forms a heat-exchange section by wrapping around the aforesaid periphery, and said heat-exchange section is heated from the periphery by a heater.
